# EUROPÄISCHE PATENTSCHRIFT

(11) **EP 0 769 872 B1**
(45) Veröffentlichungstag und Bekanntmachung des Hinweises auf die Patenterteilung: **27.02.2002**
(21) Anmeldenummer: 96202842.9
(22) Anmeldetag: 11.10.1996
(51) Int. Cl.: H04N 5/44, H04N 5/50, H04N 5/775, H03J 5/24, H04N 7/20

(54) **Schaltungsanordnung mit einer Hochfrequenz-Empfangsstufe und einer Übertragungsstufe**
Circuit with a high frequency receiver stage and a transmission stage
Circuit avec un étage de réception haute fréquence et un étage de transmission

(30) Priorität: 17.10.1995 DE 19538544
(43) Veröffentlichungstag der Anmeldung: 23.04.1997
(73) Patentinhaber: Philips Corporate Intellectual Property GmbH, 52064 Aachen (DE); Koninklijke Philips Electronics N.V., 5621 BA Eindhoven (NL)
(72) Erfinder: Ruitenburg, Leo, 22335 Hamburg (DE)
(74) Vertreter: Peters, Carl Heinrich, Dipl.-Ing.

(56) Entgegenhaltungen:
- EP-A- 0 304 611
- EP-A- 0 348 697
- EP-A- 0 678 981
- EP-A- 0 679 024
- US-A- 4 157 505
- US-A- 4 379 271
- US-A- 4 667 243
- US-A- 4 894 720
- US-A- 5 420 646
- IEEE TRANSACTIONS ON CONSUMER ELECTRONICS, Bd. 38, Nr. 3, 30.August 1992, NEW YORK US, Seiten 389-392, XP000311869 MAIER G. ET AL: "NEW HIGH DENSITY MULTISTANDARD RF-CONCEPT FOR VCR"
- ELECTRONIC COMPONENTS AND APPLICATIONS, Bd. 9, Nr. 4, 30.April 1989, EINDHOVEN NL, Seiten 240-252, XP000159337 BAARS N.: "ICs and Discrete Semiconductors for TV and VCR tuners"

## Beschreibung

Die Erfindung bezieht sich auf eine Schaltungsanordnung mit einer Hochfrequenz-Empfangsstufe (*auch als* Tuner *bezeichnet*) und einer eine Signalaufteilschaltung (*auch als* Splitter *bezeichnet*) und eine Modulationsanordnung (*auch als* Modulator *bezeichnet*) umfassenden Übertragungsstufe (*auch als* Splitter-Modulator *bezeichnet*), wobei die Signalaufteilschaltung einen Hochfrequenzsignaleingang zum Zuführen eines Hochfrequenzeingangssignals, einen Hochfrequenzsignalausgang zum Abgeben eines Hochfrequenzausgangssignals, eine erste Leitung zum Abgeben des Hochfrequenzeingangssignals an die Empfangsstufe und eine zweite Leitung zum Zuführen eines Hochfrequenzausgangssignals von der Modulationsanordnung *an die Signalaufteilschaltung* aufweist und wobei die Empfangsstufe zum Demodulieren des Hochfrequenzeingangssignals und die Modulationsanordnung zum Umsetzen eines Basisbandsignals in das von ihr abzugebende Hochfrequenzausgangssignal eingerichtet ist, mit Einrichtungen zum Erzeugen von Referenzschwingungen für die Hochfrequenz-empfangsstufe und die Übertragungsstufe, wobei diese Einrichtungen einen für die Hochfrequenz-Empfangsstufe und die Übertragungsstufe gemeinsamen Schwingquarz und eine für die Hochfrequenz-Empfangsstufe und die Übertragungsstufe gemeinsame phasenverriegelte Schleife aufweisen.

Eine derartige Schaltungsanordnung ist in der europäischen Patentanmeldung 95 200 961.1 (EP-A-679 024) beschrieben. Durch diese beschriebene Schaltungsanordnung wird ein geringer Schaltungsaufwand für eine Schaltungsanordnung angestrebt, die sowohl einen Tuner als auch einen Splitter-Modulator umfaßt. Dabei ist als besonders auf wandsarme Anordnung angegeben, daß sowohl für die Modulationsanordnung in der Signalaufteilschaltung als auch für die Hochfrequenz-Empfangsstufe nur ein einziger Schwingungsgenerator mit einer einzigen Oszillatorstufe zur Anwendung kommt.

Es zeigt sich, daß zur Abstimmung der Hochfrequenz-Empfangsstufe auf verschiedene Sender ein Gleichlauf der Verstimmung von Filterstufen in der Hochfrequenz-Empfangsstufe mit der Verstimmung der Oszillatorstufe erforderlich ist, der für hohe Anforderungen an die Güte der Signalverarbeitung einen zu hohen Aufwand bei der Dimensionierung der Abstimmelemente der Filterstufen und der Oszillatorstufe erfordert.

*In IEEE Transactions on Consumer Electronics, Bd. 38, Nr. 3 vom 30. August 1992, New York US, Seiten 389-392, Maier G. et al.: "New High Density Multistandard RF-Concept For VCR" ist ein kompaktes Multistandard-VCR-Konzept beschrieben, welches einen Leistungsteiler, einen Antennenschalter, einen Modulator und einen Tuner umfaßt. Darin sind der Tuner und das Modulatorkonzept PLL-gesteuert und die Modulatorfrequenz ist zum oberen Ende des UHF-Bandes hin verschoben. Sowohl für den Tuner als auch für den Modulator werden getrennte Oszillatoren verwendet.*

Die Erfindung hat die Aufgabe, bei einer Schaltungsanordnung der vorstehend genannten Art einerseits einen möglichst kompakten Aufbau durch Verwendung möglichst weniger Bauteile und andererseits möglichst geringe Herstellungskosten zu erreichen.

Diese Aufgabe wird bei der Schaltungsanordnung der gattungsgemäßen Art nach der Erfindung dadurch gelöst, daß die Hochfrequenz-Empfangsstufe wenigstens zwei Signalverarbeitungszweige zum frequenzselektiven *Empfangen*, Verstärken und/oder Frequenzmischen der Hochfrequenzsignale je eines Frequenzbereiches (*auch als Band* *bezeichnet*) umfaßt und die Einrichtungen zum *Erzeugen* von Referenzschwingungen (*auch als* Schwingungsgenerator *bezeichnet*) zu jedem Signalverarbeitungszweig eine gesonderte Oszillatorstufe umfassen, wobei eine dieser Oszillatorstufen auch zur Erzeugung der Referenzschwingung für die Übertragungsstufe dient.

Bei der erfindungsgemäßen Schaltungsanordnung wird somit für jeden Frequenzbereich in jedem zugehörigen Signalverarbeitungszweig eine gesonderte Oszillatorstufe eingesetzt. Diese kann optimal auf die Filterstufen dieses Signalverarbeitungszweiges angepaßt werden. Eine sehr aufwendige Anpassung einer einzigen Oszillatorstufe an Filterstufen verschiedener Signalverarbeitungszweige für unterschiedliche Frequenzbereiche wird damit vermieden. Andererseits wird eine der Oszillatorstufen jedoch auch für die Modulationsanordnung zum Liefern einer hierfür erforderlichen Trägerschwingung herangezogen. Je nach dem Frequenzbereich, in welchen von der Modulationsanordnung das Hochfrequenzausgangssignal abgegeben werden soll, kann die Modulationsanordnung - im Fall mehrerer Signalverarbeitungszweige mehrere Frequenzbereiche in der Hochfrequenz-Empfangsstufe - mit der geeigneten Oszillatorstufe verbunden werden. Besonders einfach wird der Betrieb der Schaltungsanordnung dadurch, daß entweder nur die Hochfrequenz-Empfangsstufe oder nur die Modulationsanordnung betrieben werden; jedoch ermöglicht die Erfindung auch einen gleichzeitigen Betrieb.

Ausführungsbeispiele der Erfindung sind in der Zeichnung, in der übereinstimmende Elemente mit identischen Bezugszeichen versehen sind, dargestellt und werden im nachfolgenden näher beschrieben. Es zeigen
- Fig.: 1 zur Erläuterung der Begriffe einer in der europäischen Patentanmeldung 95 200 961.1 beschriebenen Schaltungsanordnung,
- Fig. 2: ein erstes und
- Fig. 3: ein zweites Ausführungsbeispiel der Erfindung.

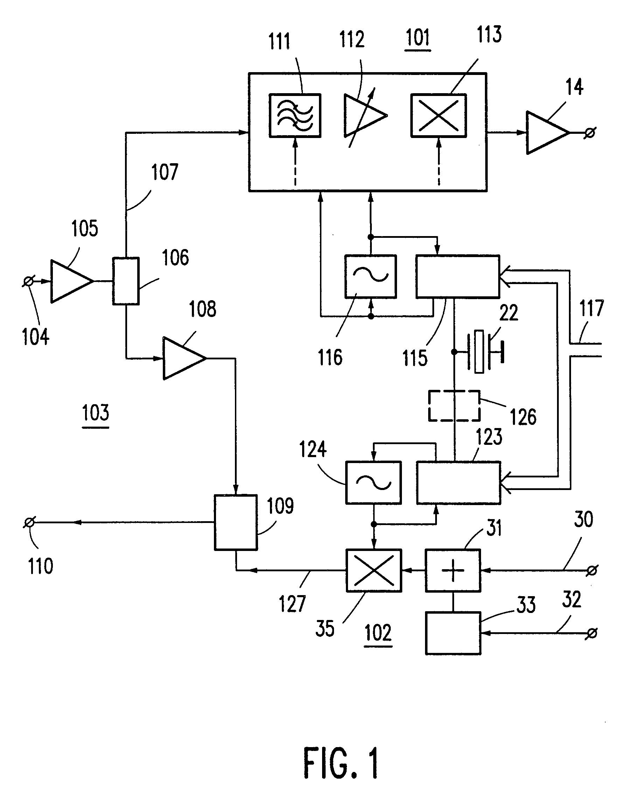

Fig. 1 zeigt eine Kombination aus einem Tuner 101, einem Modulator 102 und einem Splitter 103, wobei Modulator 102 und Splitter 103 zusammengefaßt eine Übertragungsstufe (Splitter-Modulator) darstellen. Über einen Hochfrequenzsignaleingang 104 ist dem Splitter 103 ein Hochfrequenzeingangssignal, beispielsweise ein Fernsehsignal von einer Antenne, zuführbar. Es gelangt über einen ersten Vorverstärker 105 auf eine erste Signalweiche 106 und von dieser einerseits an eine erste Leitung 107 und andererseits über einen zweiten Vorverstärker 108 an eine zweite Signalweiche 109. Von dieser kann es über einen Hochfrequenzsignalausgang 110 abgegeben werden.

Von der ersten Leitung 107 gelangt das Hochfrequenzeingangssignal an den Tuner 101, in dem in üblicher Weise eine Frequenzselektion 111, eine Amplitudenregelung 112 und eine Abwärtsmischung 113 durch dafür gebräuchliche Stufen vorgenommen wird. Über einen Ausgangsverstärker 14 wird ein Zwischenfrequenzsignal abgegeben. Den Stufen 111 für die Frequenzselektion und 113 für die Abwärtsmischung werden in an sich üblicher Weise Referenzschwingungen von einem dem Tuner 101 zugeordneten Schwingungsgenerator zugeleitet, der eine phasenverriegelte Schleife 115 und eine Oszillatorstufe 116 umfaßt. Die phasenverriegelte Schleife 115 ist zur Abstimmung des Tuners 101 über Steuerleitungen 117, vorzugsweise einen I2C-Bus, ansteuerbar.

Der Modulator 102 enthält in an sich bekannter Weise eine Audiosignal-Modulationsstufe 33, der an einem Audiosignaleingang 32 ein Audio-Basisbandsignal zuleitbar ist und der dieses auf eine Tonträgerschwingung aufmoduliert. Das modulierte Audiosignal wird in einer Niederfrequenzsignal-Überlagerungsstufe 31 einem über einen Eingang 30 zugeführten Basisband-Videosignal überlagert. Das so erhaltene, FBAS-Signal wird in einer Modulationsstufe 35 auf eine Hochfrequenz-Trägerschwingung aufmoduliert, die in einem Schwingungsgenerator des Modulators 102 erzeugt wird, der eine zweite phasenverriegelte Schleife 123 und eine zweite Oszillatorstufe 124 umfaßt. Der Schwingungsgenerator 123, 124 des Modulators 102 weist im Prinzip denselben Aufbau wie derjenige des Tuners 101 auf. Insbesondere werden beide Schwingungsgeneratoren 115, 116 und 123, 124 aus einem einzigen Kristalloszillator gesteuert, wobei zwischen dem Kristalloszillator 22 und der zweiten phasenverriegelten Schleife 123 eine Transistorkoppelstufe 126 zur Schwingungsverstärkung und niederohmigen Einkopplung angeordnet sein kann.

Von der Modulationsstufe 35 führt eine zweite Leitung 127 das Hochfrequenzausgangssignal des Modulators 102 der zweiten Signalweiche 109 des Splitters 103 zu, über die es an den Hochfrequenzsignalausgang 110 gelangt.

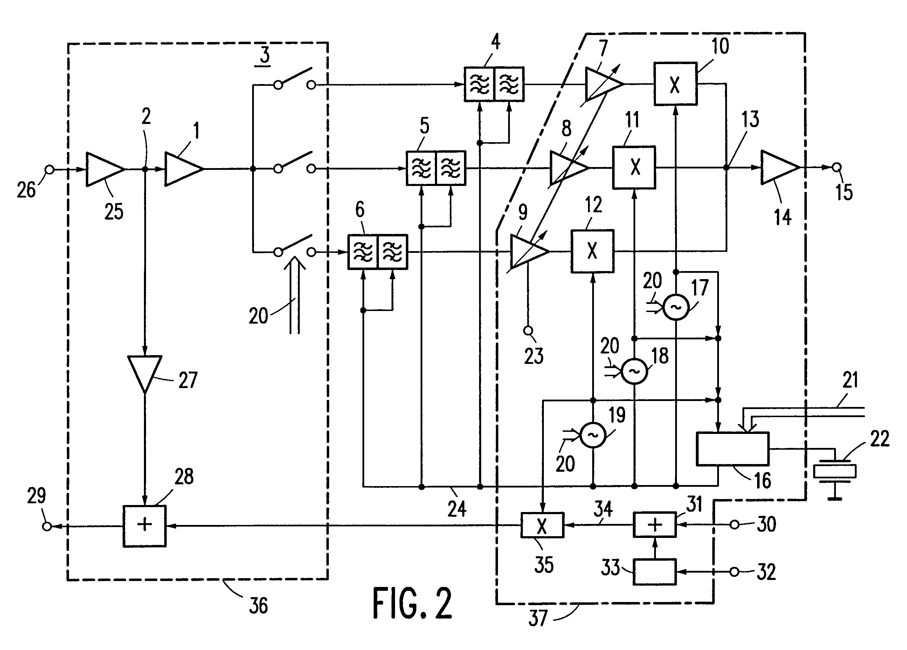

Das Ausführungsbeispiel der nach Fig. 2 umfaßt einen breitbandigen Eingangsverstärker 1, der eingangsseitig mit einem Eingang 2 für die Hochfrequenzsignale und ausgangsseitig mit einer Umschaltstufe 3 verbunden ist, sowie drei sich an die Umschaltstufe 3 anschließende Signalverarbeitungszweige mit einer abschließenden Signalzusammenführung. Jeder der Signalverarbeitungszweige umfaßt in Fig. 2 Filterstufen 4, 5 bzw. 6, die sich an die Umschaltstufe 3 anschließen, je eine steuerbare Verstärkerstufe 7, 8 bzw. 9 im Anschluß an die Filterstufen 4, 5 bzw. 6 sowie je eine Mischstufe 10, 11 bzw. 12 im Anschluß an die zugehörige steuerbare Verstärkerstufe 7, 8 bzw. 9. Vom Eingang 2 für die Hochfrequenzsignale werden diese über den breitbandigen Eingangsverstärker und die Umschaltstufe 3 wahlweise einem der Signalverarbeitungszweige zugeführt. Im Signalverarbeitungszweig wird das gewünschte, dem Signalverarbeitungszweig zugeordnete Frequenzband in der Filterstufe 4, 5 bzw. 6 selektiert. Über die steuerbaren Verstärkerstufen 7, 8 bzw. 9 werden den Mischstufen 10, 11 bzw. 12 dann die Hochfrequenzsignale ausschließlich des ausgefilterten Frequenzbandes zugeführt und in den Mischstufen 10, 11 bzw. 12 in ihrer Frequenz herabgemischt. Die Signalzusammenführung, in der Anordnung nach Fig. 2 durch einen Leitungsknoten 13 und einen Ausgangsverstärker 14 gebildet, ermöglicht eine Zufuhr der herabgemischten Hochfrequenzsignale zu einem gemeinsamen Ausgang 15. Begrifflich kann dabei wahlweise die Signalzusammenführung auch nur den Leitungsknoten umfassen; der Ausgangsverstärker 14 gehört dann zusammen mit dem Ausgang 15 bereits zu einem für alle Signalverarbeitungszweige gemeinsamen Ausgangszweig.

Zur Erzeugung der zum Herabmischen der Hochfrequenzsignale benötigten Schwingungen dient in der Anordnung nach Fig. 2 ein gemeinsamer Schwingungsgenerator, der eine allen Signalverarbeitungszweigen gemeinsame phasenverriegelte Schleife 16 und zu jedem der Signalverarbeitungszweige eine gesonderte Oszillatorstufe 17, 18 bzw. 19 umfaßt. Die phasenverriegelte Schleife 16 und die Oszillatorstufen 17, 18 bzw. 19 sind in an sich bekannter Weise miteinander verbunden. Um gegenseitige Störungen der Signalverarbeitungszweige auszuschließen, können die Oszillatorstufen 17, 18, 19 wahlweise über eine Datenleitung 20 ein- bzw. ausgeschaltet werden, so daß nur jeweils die Oszillatorstufe 17, 18 bzw. 19 eine Schwingung abgibt, deren Signalverarbeitungszweig über die Umschaltstufe 3 mit dem Eingang 2 (über den Eingangsverstärker 1) verbunden ist. Die Datenleitung 20 kann dann in gleicher Weise auch an die Umschaltstufe 3 geführt sein. Außerdem ist über einen Dateneingang 21 der phasenverriegelten Schleife 16 die Frequenz der vom Schwingungsgenerator 16 bis 19 abgegebenen Schwingung einstellbar. Der Schwingungsgenerator 16 bis 19 ist ferner mit einem Kristalloszillator 22 als Frequenzreferenz verbunden.

Die steuerbaren Verstärkerstufen 7, 8, 9 weisen einen Steuereingang 23 auf, über den der Verstärkungsfaktor der Verstärkerstufen 7, 8, 9 einstellbar ist. Die steuerbaren Verstärkerstufen 7, 8, 9 können dann in eine Regelschleife zur Amplitudenregelung bzw. Leistungsregelung der Hochfrequenzsignale eingebunden werden.

Die Datenleitung 20 sowie der Dateneingang 21 der phasenverriegelten Schleife 16 können mit einer nicht dargestellten Steuerung für den Empfangsbetrieb der Hochfrequenz-Empfangsstufe verbunden sein.

Die Filterstufen 4, 5, 6 sind über eine Leitung 24 der phasenverriegelten Schleife 16 verbunden. Über diese Leitung 24 können in an sich üblicher Weise Signale für die Frequenzselektion vom Schwingungsgenerator 16 bis 19 zugeführt werden. Insbesondere erhalten in den Filterstufen 4, 5, 6 vorhandene Abstimmdioden die gleiche Abstimmung wie die Oszillatorstufen 17, 18, 19.

Fig. 2 zeigt weiterhin die Einbindung der im vorstehenden beschriebenen Ausführungsform der Hochfrequenz-Empfangsstufe in eine Hochfrequenz-Signalverarbeitung eines Videorecorders. Dazu ist in Fig. 2 eine weitere Eingangsverstärkerstufe 25 dargestellt, die eingangsseitig mit einem Antenneneingang 26 des Videorecorders und ausgangsseitig mit dem Eingang 2 der Hochfrequenz-Empfangsstufe für die Hochfrequenzsignale verbunden ist. Der Eingang 2 ist ferner über einen Durchschleifverstärker 27 mit einem Eingang einer Hochfrequenzsignal-Überlagerungsstufe 28 verbunden. Deren Ausgang bildet einen Antennenausgang 29 des Videorecorders.

Ein Eingang 30 für das Basisband-Videosignal bildet einen ersten Eingang einer Niederfrequenz-Signal-Überlagerungsstufe 31. Ein Eingang 32 für ein Audiosignal ist an eine Audiosignal-Modulationsstufe 33 geführt. Diese ist mit einem zweiten Eingang der Niederfrequenzsignal-Überlagerungsstufe 31 verbunden. In der Audiosignal-Modulationsstufe 33 wird das vom Eingang 32 zugeführte Audiosignal auf eine Hilfsträgerschwingung aufmoduliert und anschließend in der Niederfrequenzsignal-Überlagerungsstufe 31 dem Basisband-Videosignal vom Eingang 30 additiv überlagert. Auf diese Weise wird ein FBAS-Signal erzeugt und über einen Ausgang 34 der Niederfrequenz-Überlagerungsstufe 31 abgegeben. Der Ausgang 34 führt an eine Modulationsstufe 35, in der das FBAS-Signal mit einer Schwingung von einer der Oszillatorstufen, hier der Oszillatorstufe 19 für den dritten Signalverarbeitungszweig, aufwärts gemischt wird. Dabei entsteht ein Hochfrequenzsignal, welches der Hochfrequenzsignal-Überlagerungsstufe 28 zur Weiterleitung an den Antennnenausgang 29 des Videorecorders zugeführt wird.

In Fig. 2 sind die durch die gestrichelte Linie 36 umrandeten Elemente vorteilhaft zu einer integrierten Baugruppe zusammengefaßt. Entsprechend können die durch die strichpunktierte Linie 37 umrandeten Elemente zu einer weiteren integrierten Baugruppe zusammengefaßt sein. Diese integrierten Baugruppen können insbesondere auf einem Halbleiterkörper integriert werden.

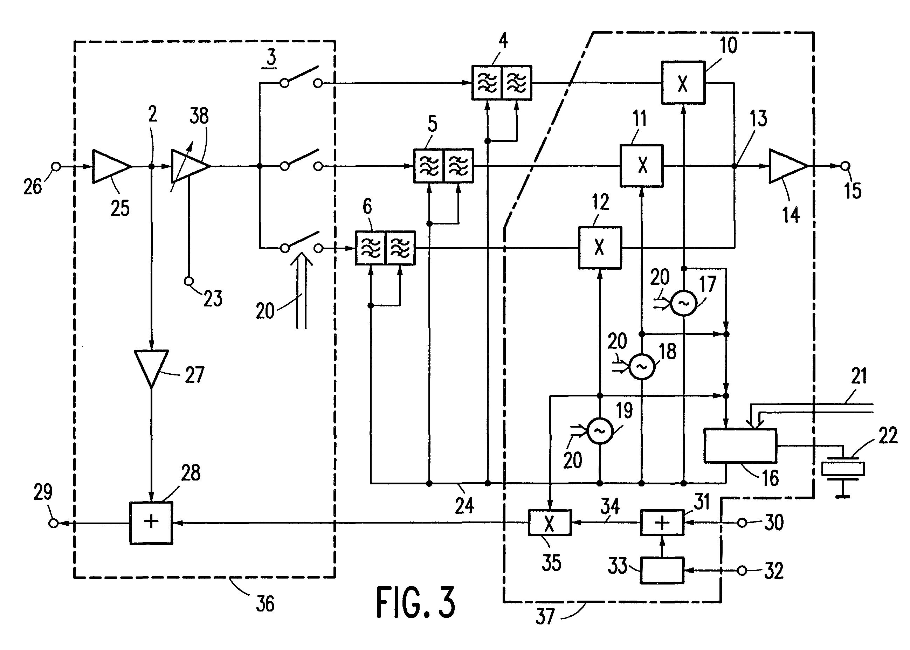

Fig. 3 zeigt ein zweites Ausführungsbeispiel der erfindungsgemäßen Hochfrequenz-Empfangsstufe. Darin wurde gegenüber dem Ausführungsbeispiel nach Fig. 2 der breitbandige Eingangsverstärker 1 durch einen breitbandigen steuerbaren Eingangsverstärker 38 ersetzt, der nun zum Zweck einer Amplituden- bzw. Leistungsregelung der Hochfrequenzsignale mit dem Steuereingang 23 verbunden ist. Dagegen entfallen die steuerbaren Verstärkerstufen 7, 8, 9 in den Signalverarbeitungszweigen; sie können in einer Abwandlung der Fig. 3 gegebenenfalls durch Verstärkerstufen mit konstanten Verstärkungsfaktoren ersetzt werden, sofern an diesen Stellen der Schaltungsanordnung eine weitere Signalverstärkung oder Rückflußdämpfung erwünscht ist.

Im übrigen stimmen die Ausführungsbeispiele nach den Figuren 2 und 3 überein.

In den vorstehend beschriebenen Figuren umfaßt der Tuner 101 die mit den Bezugszeichen 3 bis 13 in den Figuren 2 und 3 bezeichneten Elemente, der Modulator 102 die Elemente 30 bis 35 und der Splitter 103 enthält vorzugsweise die Elemente 1, 2, 25, 27 und 28 in den Ausführungsbeispielen der Figuren 2 und 3. Da der Splitter nach Fig. 1 mit der zweiten Signalweiche 109, die in ihrer Funktion der Hochfrequenzsignal-Überlagerungsstufe 28 in den Figuren 2 und 3 entspricht, nicht nur eine Signalaufteilung, sondern auch eine Signalzusammenfassung ausführt, kann er auch als Splitter-Kombinierer bezeichnet werden. Dabei übernimmt die erste Signalweiche 106 die Aufgabe des Eingangs 2 für die Hochfrequenzsignale. Weiterhin entspricht der Hochfreqeunzsignaleingang 104 dem Antenneneingang 26 des Videorecorders, der erste Verstärker 105 der weiteren Eingangsverstärkerstufe 25, der zweite Vorverstärker 108 dem Durchschleifverstärker 27 und der Hochfrequenzsignalausgang 110 dem Antennenausgang 29 des Videorecorders. Die Frequenzselektion 111 in Fig. 1 wird in den Figuren 2 und 3 durch die Filterstufen 4 bis 6 und die Amplitudenregelung 112 durch die steuerbaren Verstärkerstufen 7 bis 9 vorgenommen, die Abwärtsmischung 113 erfolgt in den Mischstufen 10 bis 12.

In den Figuren 2 und 3 erfüllt der Dateneingang 21 die Funktion der Steuerleitungen 117 aus Fig. 1.

Eine bevorzugte Anwendung der Erfindung liegt bei Hochfrequenz-Verarbeitungsstufen von Satelliten-Empfangsanlagen und Videorecordern.

## Patentansprüche

1. Schaltungsanordnung mit einer Hochfrequenz-Empfangsstufe (101) und einer eine Signalaufteilschaltung (103) und eine Modulationsanordnung (102) umfassenden Übertragungsstufe (102, 103), wobei die Signalaufteilschaltung (103) einen Hochfrequenzsignaleingang (104) zum Zuführen eines Hochfrequenzeingangssignals, einen Hochfrequenzsignalausgang (110) zum Abgeben eines Hochfrequenzausgangssignals, eine erste Leitung (107) zum Abgeben des Hochfrequenzeingangssignals an die Empfangsstufe (101) und eine zweite Leitung (127) zum Zuführen eines Hochfrequenzausgangssignals von der Modulationsanordnung (102) *an die Signalaufteilschaltung (103)* aufweist und wobei die Empfangsstufe (101) zum Demodulieren des Hochfrequenzeingangssignals und die Modulationsanordnung (102) zum Umsetzen eines Basisbandsignals in das von ihr abzugebende Hochfrequenzausgangssignal eingerichtet ist, mit Einrichtungen zum Erzeugen von Referenzschwingungen (16, 17, 18, 19) für die Hochfrequenz-Empfangsstufe (101) und die Übertragungsstufe (102, 103), wobei diese Einrichtungen einen für die Hochfrequenz-Empfangsstufe (101) und die Übertragungsstufe (102, 103) gemeinsamen Schwingquarz (22) und eine für die Hochfrequenz-Empfangsstufe (101) und die Übertragungsstufe (102, 103) gemeinsame phasenverriegelte Schleife (16) aufweisen,
wobei die Hochfrequenz-Empfangsstufe (101) wenigstens *zwei* Signalverarbeitungszweige (4, 7, 10; 5, 8, 11; 6, 9, 12) zum frequenzselektiven *Empfangen,* Verstärken und/oder Frequenzmischen der Hochfrequenzsignale je eines Frequenzbereiches umfaßt und die Einrichtungen zum *Erzeugen* von Referenzschwingungen (16, 17, 18, 19) zu jedem Signalverarbeitungszweig (4, 7, 10; 5, 8, 11; 6, 9, 12) eine gesonderte Oszillatorstufe (17, 18, 19) umfassen, wobei eine dieser Oszillatorstufen (19) auch zur Erzeugung der Referenzschwingung für die Übertragungsstufe (102, 103) dient.

## Claims

1. A circuit arrangement comprising a tuner (101) and a splitter-modulator (102,103) comprising a splitter (103) and a modulator (102), the splitter (103) having an RF signal input (104) for applying an RF input signal, an RF signal output (110) for supplying an RF output signal, a first line (107) for applying the RF input signal to the tuner (101) and a second line (127) for supplying an RF output signal from the modulator (102) to the splitter (103), the tuner (101) being adapted to demodulate the RF input signal and the modulator (102) being adapted to convert a baseband signal into the RF output signal to be supplied by said modulator, and comprising devices (16,17,18,19) for generating reference oscillations for the tuner (101) and the splitter-modulator (102,103), said devices having at least one quartz crystal (22) which is common for the tuner (101) and the splitter-modulator (102,103), and a phase-locked loop (16) which is common for the tuner (101) and the splitter-modulator (102,103), the tuner (101) comprising at least two signal-processing branches (4,7,10; 5,8,11; 6,9,12) for frequency-selective reception, amplification and/or frequency conversion of the RF signals of each frequency band, and the devices (16,17,18,19) for generating reference oscillations comprising a separate oscillator stage (17,18,19) for each signal-processing branch (4,7,10; 5,8,11; 6,9,12), one of these oscillator stages (19) also being used for generating the reference oscillation for the splitter-modulator (102,103).

## Revendications

1. Circuit avec un étage de réception à haute fréquence (101) et un étage de transmission (102, 103) comprenant un répartiteur de signal (103) et un dispositif de modulation (102), le circuit répartiteur de signal (103) comprenant une entrée de signal à haute fréquence (104) en vue d'amener un signal d'entrée à haute fréquence, une sortie de signal à haute fréquence (110) en vue de délivrer un signal de sortie à haute fréquence, une première ligne (107) en vue de délivrer le signal d'entrée à haute fréquence à l'étage de réception (101) et une deuxième ligne (127) en vue d'amener un signal de sortie à haute fréquence du dispositif de modulation (102) au circuit répartiteur de signal (103) et l'étage de réception (101) étant agencé en vue de la démodulation du signal d'entrée à haute fréquence et le dispositif de modulation (102) en vue de la transformation d'un signal en bande de base en signal de sortie à haute fréquence à délivrer par celui-ci, avec des dispositifs de production d'oscillations de référence (16, 17, 18, 19) pour l'étage de réception à haute fréquence (101) et l'étage de transmission (102, 103), ces dispositifs présentant un quartz oscillant (22) commun pour l'étage de réception à haute fréquence (101) et l'étage de transmission (102, 103) et une boucle (16) à verrouillage de phase commune pour l'étage de réception à haute fréquence (101) et l'étage de transmission (102, 103),
**caractérisé en ce que** l'étage de réception à haute fréquence (101) comporte au moins deux branches de traitement de signal (4, 7, 10; 5, 8,11; 6,9, 12) en vue de la réception à sélection de fréquence, de l'amplification et/ou du mixage de fréquences des signaux à haute fréquence de respectivement une plage de fréquence et les dispositifs de production d'oscillations de référence (16, 17, 18, 19) comprennent pour chaque branche de traitement de signal (4, 7, 10, 5,8, 11; 6,9, 12) un étage oscillateur séparé (17, 18, 19), l'un de ces étages oscillateurs (19) servant également à la production de l'oscillation de référence pour l'étage de transmission (102, 103).
